# EUROPÄISCHE PATENTANMELDUNG

(11) **EP 3 352 028 A1**
(43) Veröffentlichungstag der Anmeldung: **25.07.2018**
(21) Anmeldenummer: 17152600.7
(22) Anmeldetag: 23.01.2017
(51) Int. Cl.: G05B 17/02, G06F 11/26, G06F 11/36, G06F 17/50

(54) **VERFAHREN ZUM TEST EINER STEUERGERÄTEFUNKTION EINES STEUERGERÄTS EINES FAHRZEUGS**

(71) Anmelder: dSPACE digital signal processing and control engineering GmbH, 33102 Paderborn (DE)
(72) Erfinder: Pretsch, Christian, 33184 Altenbeken (DE); Amelunxen, Hendrik, 33184 Altenbeken (DE)

(57) **Zusammenfassung**

Ein Simulator (5) und ein Verfahren (1) zum Test einer Funktion (f_{ECU}) eines Steuergeräts (2) eines Fahrzeugs (3a). Das Fahrzeug umfasst Umgebungssensoren, z.B. Radar (6a,6b), Kamera (6c) und Funkempfänger (6d), die als Eingänge für die Steuergerätefunktion (f_{ECU}) bzw. das Steuergerät (2) dienen, wobei diese als ein Fahrzeugmodell (12a), Sensormodelle (13) und ein Umgebungsmodell (14) in einem mehrere Recheneinheiten (4a,4b,4c) und einen Speicher aufweisenden Simulator (5) verteilt simuliert werden. Die Simulation der Steuergerätefunktion (f_{ECU}) und die Simulation als dessen Eingänge dienende Fahrzeugmodell (12a), Sensormodelle (13) und Umgebungsmodell (14) werden synchron auf den Recheneinheiten (4a,4b,4c) gestartet, wobei der Datenaustausch über den Speicher erfolgt. Durch die auf mehreren Recheneinheiten (4a,4b,4c) verteilte Simulation und den Datenaustausch über den Speicher wird eine hohe Simulationsgeschwindigkeit erzielt. Das Steuergerät (2) muss zur Simulation nicht zwingend real vorhanden sein. Durch Einbezug von z.B. Daten von anderen Fahrzeugen (3b), Straßen (8), Gebäuden (9), Verkehrsschildern (10) oder Lichtzeichen (11), können Verkehrssituationen simuliert werden.

## Beschreibung

Die Erfindung betrifft ein Verfahren zum Test wenigstens einer Steuergerätefunktion wenigstens eines Steuergeräts wenigstens eines ersten Fahrzeugs, mittels eines mehrere Recheneinheiten aufweisenden Simulators, wobei das erste Fahrzeug wenigstens einen ersten Umgebungssensor aufweist, wobei eine Mehrzahl von Umgebungssensoren des ersten Fahrzeugs und/oder wenigstens eines weiteren Fahrzeugs das wenigstens eine Steuergerät und/oder weitere Steuergeräte mit Sensordaten der Umgebungssensoren speisen, die wenigstens eine Steuergerätefunktion zumindest einen Teil der Sensordaten als Eingangsgrößen verarbeitet, und das erste Fahrzeug und, soweit vorhanden, die weiteren Fahrzeuge sich in einer eine Verkehrssituation darstellenden Umgebung befinden, wobei das erste Fahrzeug mittels eines ersten Fahrzeugmodells, und, soweit vorhanden, die weiteren Fahrzeuge mittels weiterer Fahrzeugmodelle, die Umgebungssensoren mittels Sensormodellen und die Umgebung mittels eines Umgebungsmodells mit den Recheneinheiten des Simulators simuliert werden, wobei die Modelle alleine oder in Gruppen auf wenigstens zwei Recheneinheiten mit jeweils direkt zugreifbarem Speicher verteilt werden, wobei das Umgebungsmodell statische und dynamische Umgebungsdaten umfasst, wobei die Sensormodelle als Eingangsgrößen die statischen und/oder dynamischen Umgebungsdaten aufweisen. Weiterhin betrifft die Erfindung einen Simulator zur Durchführung des erfindungsgemäßen Verfahrens.

Das vorgenannte Verfahren kommt im weiten Feld der Steuergeräteentwicklung, der Entwicklung von Steuergerätefunktionalitäten und deren Test zum Einsatz. Die computergestützte und modellbasierte Entwicklung von Steuergerätefunktionalitäten bis hin zur Implementierung der Steuergerätefunktionalitäten auf den letztlich zum Einsatz kommenden Seriensteuergeräten ist seit vielen Jahren bekannt. Eine etablierte Vorgehensweise ist das sogenannte V-Modell. Hier werden Steuergerätefunktionalitäten zunächst in einer Simulationsumgebung, die keine Ähnlichkeit mit der Hardware des später zum Einsatz kommenden Steuergeräts hat, vollkommen entkoppelt von dem tatsächlichen physikalischen Prozess - beispielsweise einem Fahrzeug - entwickelt. Die so erhaltenen Funktionalitäten werden kann auf einem leistungsfähigen Entwicklungs-Steuergerät implementiert und im realen Prozess erprobt. Schließlich erfolgt die Übertragung der Steuergerätefunktionalität auf die schlussendlich zum Einsatz kommende Zielhardware, also das Seriensteuergerät, dessen Hardware - auch hinsichtlich Kostengesichtspunkten - abgestimmt und optimiert ist auf den zu beeinflussenden technischen Prozess.

Der Test von Steuergeräten erfolgt im Rahmen der sogenannten Hardware-inthe-Loop-Simulation (HIL-Simulation) im Zusammenhang mit leistungsfähigen Simulatoren, die die Umgebung des zu testenden Steuergeräts und der in dem Steuergerät implementierten Steuergerätefunktionalität durch die Berechnung mathematischer Modelle simulieren. Liegt das zu testende Steuergerät real vor, dann sind derartige Simulatoren auch in der Lage, die simulierten Umgebungsdaten über entsprechende I/O-Schnittstellen an das Steuergerät auszugeben. Umgekehrt können von dem Steuergerät ausgegebene Signale ebenso über entsprechende I/O-Schnittstellen empfangen und in das im Simulator berechnete Modell eingespeist werden.

Es ist von großem Interesse, die Steuergerätefunktionalität möglichst frühzeitig mit der tatsächlich zum Einsatz kommenden Steuergerätesoftware zu testen. Aus diesem Grunde ist man zwischenzeitlich dazu übergegangen, auch das Seriensteuergerät, also die Steuergerätehardware oder zumindest die hardwarenahe Software, durch ein mathematisches Modell abzubilden und zu simulieren. Ein solches Steuergerät kann in ganz unterschiedlichem physikalischen Detaillierungsgrad simuliert werden. Da es real nicht vorliegt, wird hier häufig von einem virtuellen Steuergerät gesprochen (VECU=Virtual Electronic Control Unit).

Wenn davon die Rede ist, dass der Simulator im Rahmen der HIL-Simulation die Umgebung des zu testenden Steuergeräts mit der in dem Steuergerät implementierten Steuergerätefunktionalität simuliert, dann ist damit die signalmäßige Umgebung des Steuergeräts zu verstehen. Wenn es sich beispielsweise um ein Motorsteuergerät handelt, dann umfasst die signalmäßige Umgebung des Steuergeräts typischerweise solche Signale, die für die Motorsteuerung von Belang sind, also beispielsweise die Drehwinkel der Kurbelwelle und der Pleuelstange, Ventilstellungen, Zylinderkopftemperatur, Stellung des Gaspedals usw. Die Sensordaten werden also im Wesentlichen von Sensoren geliefert, die interne Fahrzeugzustände messtechnisch erfassen.

Eine vergleichsweise junge Technologie beschäftigt sich mit dem Einsatz von Umgebungssensoren in einem Fahrzeug, also von Sensoren, die tatsächlich nicht interne Zustandsgrößen des Fahrzeugs erfassen, sondern im umgangssprachlichen Sinne die Umgebung eines Fahrzeugs erfassen und entsprechende Sensordaten erzeugen. Bei derartigen Umgebungssensoren kann es sich zum Beispiel um Radarsensoren handeln, die mit hoher Genauigkeit Abstandsinformationen liefern, es kann sich um optische Sensoren - also Kameras - handeln, mit deren Sensordaten in ihrem optischen Erfassungsbereich eine Analyse der aufgenommenen Verkehrssituation vorgenommen und so beispielsweise Informationen über die Beschilderung der Umgebung bereitgestellt werden können, es kann sich bei den Umgebungssensoren auch um Antennen mit Auswerteelektronik handeln, die von umgebenden Fahrzeugen ausgesandte Information hinsichtlich der Position und Bewegung dieser Fahrzeuge erfassen und auswerten. Es gibt eine Fülle weiterer Umgebungssensoren, die Informationen über die Umgebung eines Fahrzeugs liefern.

Der Einsatz von Umgebungssensoren spielt häufig im Rahmen von Fahrer-Assistenzsystemen (ADAS = Advanced Driver Assistance Systems) oder autonomen Fahrzeugsteuerungen (HAD = Highly Automated Driving) eine Rolle. Es ist ohne Weiteres ersichtlich, dass Umgebungssensoren häufig eine immense Datenmenge erfassen und verarbeiten müssen. Entsprechend anspruchsvoll ist auch die Simulation von vollständigen Umgebungen eines Steuergeräts, das in einem Fahrzeug verbaut ist und mit Sensordaten von Umgebungssensoren gespeist wird. Dabei muss das Steuergerät nicht zwingend mit Sensordaten von Umgebungssensoren des eigenen Fahrzeugs gespeist werden (eingangs erstes Fahrzeug genannt), es kann durchaus sein, dass das Steuergerät mit Sensordaten von Umgebungssensoren weiterer Fahrzeuge gespeist wird, die beispielsweise über die zuvor angesprochene Antenne des ersten Fahrzeugs empfangen werden.

Wenn es einleitend heißt, dass eine Mehrzahl von Umgebungssensoren des ersten Fahrzeugs und/oder wenigstens eines weiteren Fahrzeugs das wenigstens eine Steuergerät und/oder weitere Steuergeräte mit Sensordaten der Umgebungssensoren speisen, dann sind damit mehrere mögliche Szenarien gemeint, denen gemeinsam ist, dass eine Mehrzahl von Umgebungssensoren vorhanden ist, also wenigstens zwei Umgebungssensoren vorhanden sind. Wo diese Umgebungssensoren verortet sind, also in einem oder mehreren Fahrzeugen, und wieviele Steuergeräte und Steuergerätefunktionen sie speisen, ist nicht entscheidend. Es können beispielsweise mehrere Umgebungssensoren in einem Fahrzeug verbaut sein, es können aber auch jeweils ein Umgebungssensor in mindestens zwei verschiedenen Fahrzeugen verbaut sein. Die wenigstens zwei Umgebungssensoren können verschiedene Steuergeräte speisen, sie können aber auch nur ein einziges Steuergerät speisen.

Der Einsatz von Umgebungssensoren, die die Umgebung des Fahrzeugs, in dem sie verbaut sind, erfassen (hier wird der Begriff "Umgebung" also auch in seiner umgangssprachlichen und nicht nur signalbezogenen Bedeutung verwendet), macht bei einer Simulation die mathematische Abbildung aller beteiligten Komponenten erforderlich. So wird das erste Fahrzeug mittels eines ersten Fahrzeugmodells mathematisch abgebildet und simuliert. Möglicherweise darüber hinaus vorhandene weitere Fahrzeuge werden mittels weiterer Fahrzeugmodelle mathematisch abgebildet, wobei die Modellierungstiefe der Fahrzeugmodelle variieren kann. Die Umgebungssensoren des ersten Fahrzeugs und/oder der weiteren Fahrzeuge werden mittels mathematischer Sensormodelle beschrieben und so einer Simulation zugänglich gemacht. Ebenso wird die Umgebung, in der sich die Fahrzeuge bewegen und die daher üblicherweise eine Verkehrssituation darstellt, mit einem Umgebungsmodell mathematisch abgebildet. Alle mathematischen Modelle werden dann zeitlich aufeinander abgestimmt mit den Recheneinheiten des Simulators simuliert. Aufgrund der Größe und Komplexität der mathematischen Modelle sowie der Anforderung - jedenfalls bei klassischen HIL-Tests -, die mathematischen Modelle in Echtzeit berechnen zu können, werden zur Simulation häufig Simulatoren mit mehreren Recheneinheiten verwendet. Bei den Recheneinheiten handelt es sich üblicherweise jeweils um eigenständige Prozessorboards mit einem eigenen Speicher. Die Recheneinheiten können untereinander über einen externen Datenbus Informationen austauschen und müssen im Rahmen der Simulation auch Informationen austauschen, da die verschiedenen Modelle selbstverständlich nicht unabhängig voneinander sind. Denkbar sind auch mehrere eigenständige Rechner mit eigenen Recheneinheiten und dort von der jeweiligen Recheneinheit direkt zugreifbarem Speicher, wobei die Rechner zum Datenaustausch miteinander gekoppelt werden. Genauso ist auch ein Prozessor mit mehreren Rechenkernen möglich, wobei jeder Rechenkern als Recheneinheit aufgefasst wird. Für die Berechnung des Fahrzeugmodells ist natürlich die Position des Fahrzeugs von Interesse und die damit einhergehende Verkehrssituation, die sich aus dem Umgebungsmodell ergibt. Ebenso ist die Berechnung der Sensormodelle abhängig von der Position des Fahrzeugs in der Umgebung wie aber auch von dynamischen Eigenschaften der Fahrzeugbewegung, die aus der Berechnung des Fahrzeugmodells folgt.

Das Umgebungsmodell umfasst naturgemäß statische und dynamische Umgebungsdaten. Zu den statischen Umgebungsdaten gehören alle zeitlich nicht veränderlichen Objekte in der Umgebung (Straßenführung, Bebauung, Beschilderung, aber auch statische Abmessungen von Verkehrsteilnehmern). Zu den dynamischen Umgebungsdaten zählen dann die Bewegungsdaten anderer Fahrzeuge oder beispielsweise von Fußgängern. Das Umgebungsmodell ermöglicht auf Grundlage der Umgebungsdaten beispielsweise auch die Berechnung der Positionsdaten von Verkehrsteilnehmern. Den maßgeblichen Anteil an den Umgebungsdaten machen die statischen Umgebungsdaten aus.

Im Stand der Technik sind Verfahren bekannt, mit denen Umgebungssimulationen zum Steuergerätetest durchgeführt werden können (dSPACE GmbH: "ASM Traffic, dSPACE Automotive Simulation Modells (ASM)", Produktbroschüre 2016). Eine Umgebung, d.h. eine Verkehrssituation wird dabei von einem Benutzer erstellt, indem Objekte (Straßenelemente, Verkehrsschilder, Verkehrsteilnehmer, etc...) ausgewählt und zu einer Gesamtumgebung zusammengestellt werden. Die Auswahl beim Zusammenstellen der Umgebung bewirkt eine Beschreibung der Umgebung in einem Rohformat der Umgebungsdaten. So kann für eine komplexe Umgebung leicht ein einziges, einheitliches Modell erstellt werden.

Des Weiteren ist es auch möglich, eine Umgebungsbeschreibung zu importieren, beispielsweise eine Beschreibung im sogenannten OpenDRIVE-Format. Auch dieses Format würde im Sinne der Erfindung ein Rohformat darstellen. In der Regel müssen zu Simulationszwecken die in einem Rohformat vorliegenden Daten in ein Datenstrukturformat umgewandelt werden. Gegebenenfalls würde bei importierten Daten noch eine weitere Umwandlung der Daten vollzogen, nämlich die Umwandlung der importierten (Roh-)Daten aus dem OpenDRIVE-Format in Rohdaten bzw. Objekte des Umgebungsmodellierungswerkzeugs.

Aufgabe der vorliegenden Erfindung ist es, das eingangs genannte Verfahren zum Test der Steuergerätefunktion eines Steuergeräts so weiterzuentwickeln, dass die verwendete Hardware des Simulators möglichst vorteilhaft genutzt wird, bzw. einen Simulator bereitzustellen, der eingerichtet ist, das erfindungsgemäße Verfahren auszuführen.

Die zuvor hergeleitete Aufgabe wird bei dem eingangs beschriebenen Verfahren zunächst und im Wesentlichen dadurch gelöst, dass die Sensormodelle auf wenigstens zwei Recheneinheiten mit ihren jeweils direkt zugreifbaren Speichern verteilt werden, dass die Recheneinheiten mit solchen Sensormodellen identifiziert werden, die statische Umgebungsdaten als Eingangsgrößen haben, dass in den direkt zugreifbaren Speichern der identifizierten Recheneinheiten die statischen Umgebungsdaten abgelegt werden, dass nach abgeschlossener Ablage der statischen Umgebungsdaten die Simulation der Modelle auf den Recheneinheiten mit ihren jeweils direkt zugreifbarem Speichern synchron gestartet wird, dass die Sensormodelle, die statische Umgebungsdaten als Eingangsgrößen aufweisen, die statischen Umgebungsdaten derjenigen identifizierten Recheneinheit mit ihrem direkt zugreifbaren Speicher verwenden, auf der die jeweiligen Sensormodelle selbst lokalisiert sind.

Das erfindungsgemäße Verfahren ist in verschiedener Hinsicht vorteilhaft. Die Verteilung der Sensormodelle auf wenigstens zwei Recheneinheiten führt zunächst dazu, dass die Rechenlast für die einzelnen Recheneinheiten sinkt, jedenfalls gemessen an dem Fall, dass alle Sensormodelle auf einer einzigen Recheneinheit berechnet werden. Durch die Maßnahme, dass die statischen Umgebungsdaten auf all jenen Recheneinheiten und deren direkt zugreifbarem Speicher hinterlegt werden, deren Sensormodelle mit statischen Umgebungsdaten als Eingangsgrößen arbeiten, führt zu einer wesentlichen Reduktion des Datenaustauschs, da die statischen Umgebungsdaten sich schon an den Orten befinden, an denen sie zur Berechnung gebraucht werden. Dadurch wird der Umfang der auszutauschenden Daten zwischen verschiedenen Recheneinheiten ganz erheblich reduziert. Es müssen dann gegebenenfalls noch dynamische Umgebungsdaten zwischen den Recheneinheiten ausgetauscht werden, jedoch handelt es sich hierbei vergleichsweise um nur sehr wenige Daten gegenüber den statischen Umgebungsdaten. Durch den Umstand, dass die Sensormodelle, die statische Umgebungsdaten als Eingangsgrößen aufweisen, mit den statischen Umgebungsdaten arbeiten, die auf der Recheneinheit bzw. deren direkt zugreifbarem Speicher lokalisiert sind, auf der die Sensormodelle auch selbst lokalisiert sind, wird insgesamt bewirkt, dass während der Simulation keine statischen Umgebungsdaten zwischen den Recheneinheiten des Simulators übertragen werden müssen.

Gemäß einer bevorzugten Ausgestaltung des Verfahrens ist vorgesehen, dass die statischen Umgebungsdaten vor dem Start der Simulation von einem Rohformat in ein Datenstrukturformat transformiert werden. Bei dem Rohformat der statischen Umgebungsdaten handelt es sich um eine datenmäßige Beschreibung der statischen Umgebung, die weder an die Simulationsumgebung des Simulators (Software) noch an die gerätemäßige Ausstattung des Simulators und dessen Recheneinheiten (Hardware) angepasst ist. Es kann sich beispielsweise einfach um einen langen Vektor von Double-Werten handeln. Die Umrechnung dieser Rohdaten in ein Datenstrukturformat, das von der Simulationsumgebung des Simulators verstanden wird, ist verhältnismäßig kompliziert und zeitaufwendig. Durch die Weiterbildung des Verfahrens kann die Simulation beschleunigt werden, indem die Transformation der statischen Umgebungsdaten von dem Rohformat in das Datenstrukturformat vorgreiflich erfolgt und nicht mehr Bestandteil der Simulation ist, beispielsweise nicht mehr Teil des Umgebungsmodells. Dadurch ergibt sich ein weiterer Vorteil. Nämlich dass Sensormodelle, die eine so große Menge an statischen Umgebungsdaten benötigen, dass die Kapazitäten für den Interprozessor-Datenaustausch im Rahmen einer Multiprozessorsimulation überstiegen würden, nicht auf denselben Prozessorkernen gerechnet werden müssen wie das Umgebungsmodell. Somit ergibt sich die Möglichkeit einer flexibleren Verteilung der Sensormodelle auf die Prozessoren des Simulators, unabhängig von der Platzierung des Umgebungsmodells.

Nachfolgend sind zwei Beispiele für Informationen in einem Datenstrukturformat angegeben. Das erste Beispiel zeigt die Beschreibung eines Verkehrszeichens:

```
 struct traffic_sign /* traffic signs and traffic lights */
 {
       int_T sign_type; /* type of sign: 1=light, 2=priority, 3=speed, 4=overtake, ... */
       int_T sign_value; /* specification of sign or signal */
       int_T sign_id; /* unique sign identifier */
       int_T sign_cond; /* condition of traffic sign (visibility, dirt, aging) 0..100 */
 };
```

Das zweite Beispiel betrifft eine Datenstruktur, die die Umrisse eines Verkehrsteilnehmers beschreibt:

```
 struct box_dimension /* dimension of bounding box */
 {
       real_T center_x; /* position vector (main point to center point) x-coordinate */
       real_T center_y; /* " y */
       real_T center_z; /* " z */
       real_T length_x; /* length of box in x direction */
       real_T length_y; /* " y */
       real_T length_z; /* " z */
 };
```

Eine vorteilhafte Weiterentwicklung der vorgelagerten Transformation der statischen Umgebungsdaten besteht darin, dass die statischen Umgebungsdaten vor der Ablage in den direkt zugreifbaren Speicher der identifizierten Recheneinheiten auf einem Host-Rechner von einem Rohformat in ein Datenstrukturformat transformiert werden. Dadurch wird der Simulator zusätzlich entlastet.

Gemäß einer alternativen Ausgestaltung des Verfahrens ist vorgesehen, dass die statischen Umgebungsdaten nach der Ablage in dem direkt zugreifbaren Speicher einer identifizierten Recheneinheit oder in den direkt zugreifbaren Speichern mehrerer identifizierter Recheneinheiten von der jeweiligen Recheneinheit von einem Rohformat in ein Datenstrukturformat transformiert werden, beispielsweise dadurch, dass eine entsprechende Transformationsfunktion auf der jeweiligen Recheneinheit bereitgestellt wird. Der Vorteil dieser Vorgehensweise liegt darin, dass bei der Umwandlung praktisch automatisch richtige Datenformate erzeugt werden, also beispielsweise Double-Werte in der richtigen Länge erzeugt werden, die den Erfordernissen der jeweils zugrunde liegenden Recheneinheit genügen.

Abgesehen von der Behandlung der statischen Umgebungsdaten bzw. der Durchführung der Transformation der statischen Umgebungsdaten von einem Rohformat in ein Datenstrukturformat lässt sich das erfindungsgemäße Verfahren auch hinsichtlich der Verteilung der verschiedenen Modelle auf die verschiedenen Recheneinheiten optimieren.

So ist gemäß eines bevorzugten Ausführungsbeispiels vorgesehen, dass die Sensormodelle auf möglichst wenige Recheneinheiten des Simulators verteilt werden. Dadurch wird der durch den Austausch von Umgebungsdaten bedingte Datentransfer minimiert. Diese Vorgehensweise ist deshalb vorteilhaft, weil davon auszugehen ist, dass die Berechnung der Sensormodelle allein aufgrund der dazu zu prozessierenden großen Datenmengen besonders aufwendig ist, so dass automatisch eine gute Lastverteilung erzielt wird. Es ist zusätzlich denkbar, dass auch der Modellteil des Umgebungsmodells für die Berechnung der dynamischen Daten auf diesen Recheneinheiten gerechnet wird, sodass der Datentransfer weiter minimiert wird. Durch die Konzentration der Sensormodelle auf möglichst wenige Recheneinheiten müssen gleiche Daten nur auf wenigen betroffenen Recheneinheiten vorgehalten werden, wodurch eine Lösung mit geringem Speicherbedarf erzielt wird.

Eine dazu alternative Weiterentwicklung des Verfahrens sieht vor, dass ein Fahrzeugmodell und die zu dem Fahrzeugmodell zugehörigen Sensormodelle auf einer Recheneinheit und deren direkt zugreifbaren Speicher abgelegt werden, wobei besonders bevorzugt vorgesehen ist, dass jedes Fahrzeugmodell mit seinen zugehörigen Sensormodellen auf einer eigenen separaten Recheneinheit abgelegt und dort im Rahmen der Simulation auch berechnet wird. Durch diese Ausgestaltung wird eine logische Zuordnung von Sensormodellen zu Fahrzeugmodellen gewährleistet und die Kommunikation zwischen den Recheneinheiten verkleinert. Zudem wird so auch die Anzahl der erforderlichen Recheneinheiten reduziert, da konsequent ein gesamtes Fahrzeug mit den ihm zuordenbaren Umgebungssensoren auf einer gemeinsamen Recheneinheit berechnet wird. Ein weiterer Vorteil besteht darin, dass auf dem Simulator der Austausch von Fahrzeugmodellen erheblich vereinfacht wird, da von einem solchen Austausch lediglich eine Recheneinheit betroffen ist. Zudem gewinnt die Modellierung auch an Übersichtlichkeit.

Gemäß einer weiteren Ausgestaltung des Verfahrens ist vorgesehen, dass die zu testende Steuergerätefunktion auf einem realen Steuergerät implementiert ist und das reale Steuergerät über seine Steuergerät-I/O-Schnittstelle mit einer entsprechenden Simulator-I/O-Schnittstelle mit dem Simulator verbunden ist und die simulierten Sensordaten der Umgebungssensoren auf das reale Steuergerät übertragen werden. Hierdurch werden also das physikalisch vorhandene Steuergerät und die auf ihm implementierte Steuergerätefunktion im Wege einer klassischen HIL-Simulation getestet. In diesem Fall ist es wünschenswert, dass die verschiedenen Modelle auf dem Simulator in Echtzeit berechnet werden, da das reale Steuergerät naturgemäß auch in Echtzeit betrieben wird.

Gemäß einer alternativen Vorgehensweise wird die zu testende Steuergerätefunktion auf einem virtuellen Steuergerät implementiert, wobei das virtuelle Steuergerät über seine virtuelle Steuergerät-I/O-Schnittstelle im Rahmen der Simulation die simulierten Sensordaten der Umgebungssensoren erhält. Dies entspricht der Vorgehensweise bei der Arbeit mit virtuellen Steuergeräten. Die erfindungsgemäße Verteilung der Sensormodelle auf verschiedene Recheneinheiten und die dadurch bewirkte Steigerung der Simulationsgeschwindigkeit ermöglichen es hier, Simulationen in gestauchter Zeit durchzuführen. Derart ist es dann beispielsweise möglich, eine hohe Anzahl an zu simulierenden gefahrenen Kilometern in einer sehr kurzen Zeitspanne zu durchlaufen; beispielsweise könnten eine Million Kilometer in nur 72 Stunden absolviert werden. Der Simulator kann hier mit einem PC oder einem Cluster von PCs umgesetzt werden.

Eine Optimierung der Verteilung der verschiedenen Modelle auf die Recheneinheiten des Simulators kann darüber hinaus dadurch erzielt werden, dass das erste Fahrzeugmodell, und, soweit vorhanden, die weiteren Fahrzeugmodelle, die Sensormodelle und das Umgebungsmodell gemäß einer ersten Konfiguration auf die Recheneinheiten und deren direkt zugreifbarer Speicher verteilt werden. Diese Verteilung kann automatisch erfolgen, zufällig oder gemäß bestimmter Verteilungsregeln, sie könnte aber auch von dem Benutzer vorgenommen werden. Es ist dann weiter vorgesehen, dass während einer ersten Simulation der Modelle auf den Recheneinheiten die Auslastung der Recheneinheiten ermittelt wird und dass auf Grundlage der ermittelten Auslastungen der Recheneinheiten automatisch eine Umverteilung der Modelle zu einer weiteren Konfiguration vorgenommen wird, so dass eine gleichmäßigere Auslastung der Recheneinheiten bei der Simulation der Modelle resultiert.

Die oben hergeleitete Aufgabe wird ebenfalls gelöst durch einen Simulator, der eingerichtet ist, das erfindungsgemäße Verfahren auszuführen.

Im Einzelnen gibt es nun eine Vielzahl von Möglichkeiten, das erfindungsgemäße Verfahren weiterzubilden und auszugestalten. Dazu wird verwiesen auf die dem Patentanspruch 1 nachgeordneten Patentansprüche und auf die Beschreibung bevorzugter Ausführungsbeispiele in Verbindung mit den Zeichnungen. In den Zeichnungen zeigen
- Fig. 1: schematisch Fahrzeuge mit Umgebungssensoren in einer eine Verkehrssituation darstellenden Umgebung,
- Fig. 2: schematisch einen Simulator zur Durchführung des erfindungsgemäßen Verfahrens mit Sensormodellen, die statische Umgebungsdaten benötigen, auf verschiedenen Recheneinheiten,
- Fig. 3: schematisch ein Simulator zur Durchführung des erfindungsgemäßen Verfahrens mit mehreren Fahrzeugmodellen,
- Fig. 4: einen Simulator mit einer auf Fahrzeugmodelle zentrierten Verteilung auf verschiedene Recheneinheiten,
- Fig. 5: einen Simulator gemäß Fig. 2 mit der Umwandlung von statischen Umgebungsdaten von einem Rohformat in ein Datenstrukturformat auf einem Host-Rechner,
- Fig. 6: das Ausführungsbeispiel gemäß Fig. 5 mit einer alternativen Verteilung der Umgebungsdaten in einem Datenstrukturformat auf die Recheneinheiten,
- Fig. 7: einen Simulator mit verschiedenen Recheneinheiten und einer alternativen Umwandlung statischer Umgebungsdaten von einem Rohformat in ein Datenstrukturformat,
- Fig. 8: einen Simulator mit einer alternativen Umwandlung und Verteilung von statischen Umgebungsdaten auf die Recheneinheiten und
- Fig. 9: einen Simulator mit einem angeschlossenen realen Steuergerät zum Test einer Steuergerätefunktionalität.

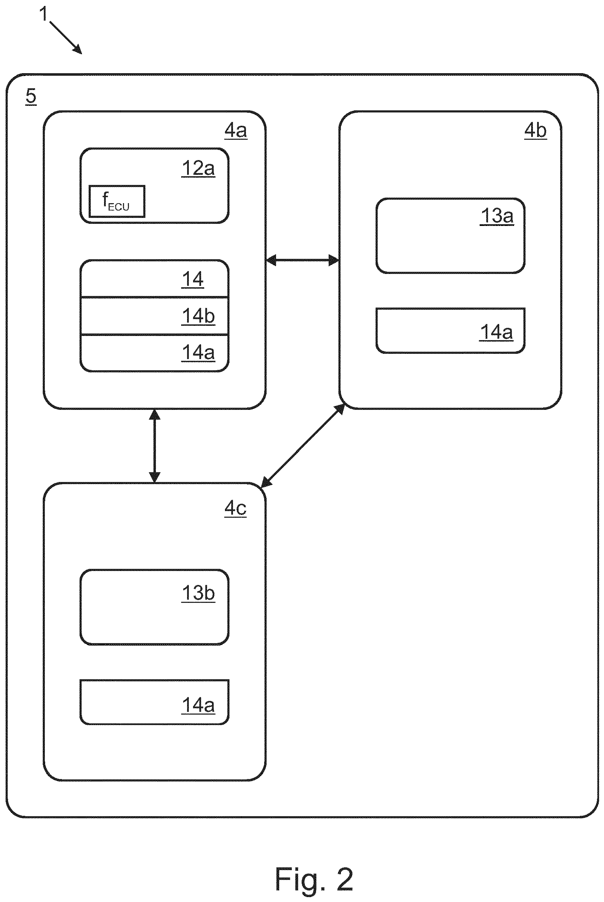

In den Fig. 2 bis 9 ist jeweils ein Verfahren 1 zum Test wenigstens einer Steuergerätefunktion f_{ECU} wenigstens eines Steuergeräts 2 wenigstens eines ersten Fahrzeugs 3a mittels eines mehrere Recheneinheiten 4, 4a, 4b, 4c aufweisenden Simulators 5 dargestellt.

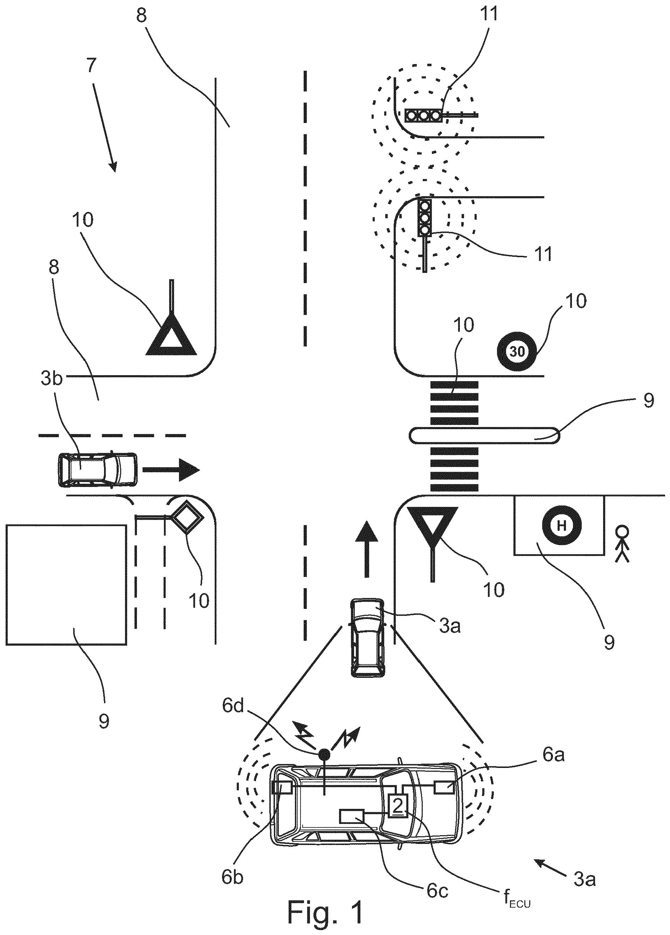

Fig. 1 zeigt schematisch Gegebenheiten und Randbedingungen, die es anhand einer Simulation von Verkehrssituationen innerhalb eines Simulators 5 nachzubilden gilt. Unten im Bild ist zunächst schematisch ein erstes Fahrzeug 3a mit einem Steuergerät 2 zu erkennen. Mit dem Steuergerät 2 verbunden sind eine Mehrzahl von Umgebungssensoren 6, nämlich Radarsensoren 6a, 6b, eine in Fahrtrichtung ausgerichtete Kamera 6c und ein Funkempfänger 6d, der beispielsweise dem Empfang von Positions- und Bewegungsdaten weiterer Fahrzeuge 3b dient. Die Umgebung 7 hat eine Verkehrssituation zum Inhalt mit Straßen 8, Gebäuden und baulichen Verkehrleitstrukturen 9, Verkehrsschildern 10 und Lichtzeichen 11.

Während sich die Fahrzeuge 3a, 3b durch die Umgebung 7 bewegen, liefern die Umgebungssensoren 6 eine Vielzahl von Sensordaten, mit denen das Steuergerät 2 gespeist wird. Die Verbindungen zwischen den Umgebungssensoren 6 und dem Steuergerät 2 sind hier als Signallinien - also als feste Verbindungen - symbolisiert, es kann sich aber auch um Funkverbindungen handeln, soweit dies technisch möglich und zulässig ist.

Die in dem Steuergerät 2 implementierte Steuergerätefunktion f_{ECU} verarbeitet zumindest einen Teil der Sensordaten als Eingangsgrößen. Von Interesse ist, ob die in dem Steuergerät 2 implementierte Steuergerätefunktion f_{ECU} wie gewünscht - also spezifikationsgemäß - funktioniert. Um dies im Rahmen einer Simulation auf dem Simulator 5 herausfinden zu können, werden die beteiligten Komponenten durch mathematische Modelle funktional abgebildet und auf den Recheneinheiten 4 des Simulators 5 berechnet.

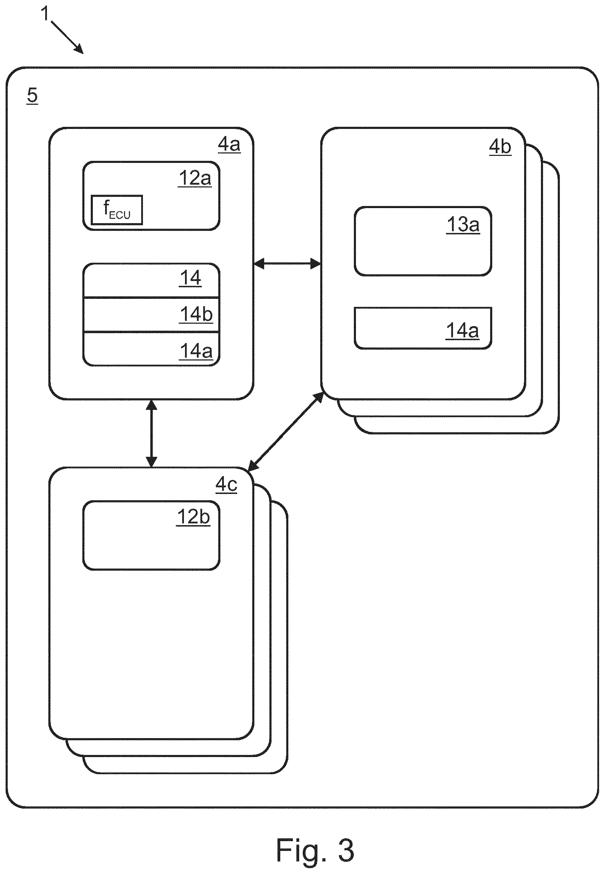

Die Berechnung der beispielhaft erläuterten Verkehrssituation gemäß Fig. 1 mit Hilfe des Simulators 5 wird nun anhand Fig. 2 beschrieben. Zunächst wird das erste Fahrzeug 3a mittels eines ersten Fahrzeugmodells 12a abgebildet. In diesem Fall umfasst das Fahrzeugmodell 12a auch ein hier nicht ausdrücklich dargestelltes Modell des Steuergeräts 2 und auch die dort implementierte und interessierende Steuergerätefunktion f_{ECU}. Sind weitere Fahrzeuge 3b an der Simulation beteiligt, werden diese in Form von weiteren Fahrzeugmodellen 12b beschrieben (siehe Fig. 3 ff.). Die Umgebungssensoren 6, 6a, 6b werden durch Sensormodelle 13, 13a, 13b modelliert und die Umgebung 7 wird mittels eines Umgebungsmodells 14 beschrieben.

Das Umgebungsmodell 14 umfasst statische Umgebungsdaten 14a und dynamische Umgebungsdaten 14b. Die statischen Umgebungsdaten 14a beschreiben statische, unbewegliche Objekte oder auch die statischen, unveränderlichen Abmessungen beweglicher Objekte, nicht jedoch deren veränderliche Positionsdaten; dies umfasst also Straßenverläufe, bauliche Objekte, Objekte zur Verkehrsführung, Schilder, Abmessungen von Fahrzeugen. Die dynamischen Umgebungsdaten 14b umfassen beispielsweise die veränderlichen Positionsdaten von Fahrzeugen 3, andere Verkehrsteilnehmer wie Fußgänger oder Radfahrer oder zeitlich veränderliche Verkehrszeichen, wie beispielsweise Lichtsignalanlagen 11.

Der Modellierungsumgebung wird erfindungsgemäß hinterlegt - z.B. durch Zusatzinformationen an den auswählbaren Objekten -, welche der Objekte des Umgebungsmodells als statische und welche als dynamische Daten zu behandeln sind, bzw. welche Daten bereits vor der Simulation eine Umwandlung in ein geeignetes Datenstrukturformat vorgenommen werden kann. Dies gilt entsprechend für importierte Daten bzw. daraus erstellte Objekte.

Wie ohne Weiteres zu erkennen ist, werden die verschiedenen Modelle 12, 13 und 14 auf die verschiedenen Recheneinheiten 4a, 4b, 4c des Simulators 5 verteilt. Der Simulator 5 ist hier ein Multiprozessorsystem.

Die Recheneinheiten 4 des Simulators 5 können untereinander Informationen austauschen, was durch die Doppelpfeile in allen Figuren angedeutet ist. Die Recheneinheiten 4 umfassen jeweils auch einen jeweils direkt zugreifbaren Speicher, der hier nicht separat dargestellt ist, genau so wenig sind im Rahmen der Recheneinheiten 4 Mikroprozessoren oder anderen Rechenwerke dargestellt. Mit einem durch die Recheneinheiten direkt zugreifbaren Speicher ist beispielsweise ein direkt adressierbarer Arbeitsspeicher gemeint, auf den innerhalb weniger Zyklen zugegriffen werden kann, oder auch das Random-Access-Memory (RAM) eines Rechenkerns. Der Zugriff auf den direkt zugreifbaren Speicher durch die Recheneinheiten 4 ist demzufolge extrem schnell, jedenfalls extrem schnell gegenüber einem Zugriff auf einen nicht direkt zugreifbaren Speicher, also beispielsweise auf den Speicher einer anderen Recheneinheit, der nur über den externen Datenkanal (Doppelpfeile zwischen den Recheneinheiten 4a, 4b, 4c) erfolgen kann. Im allgemeinen Fall erhalten die Sensormodelle 13 als Eingangsgrößen die statischen 14a und/oder dynamischen 14b Umgebungsdaten.

Im Rahmen der Erfindung ist erkannt worden, dass dem Datenaustausch zwischen den Recheneinheiten 4a, 4b, 4c im Rahmen der Simulation auf dem Simulator 5 eine entscheidende Bedeutung zukommt und der Datenaustausch dafür bestimmend sein kann, ob eine Simulation sehr schnell oder eher langsam durchgeführt werden kann. Um bei einer Berechnung auf einem mehrere Recheneinheiten 4 aufweisenden Simulator 5 eine möglichst hohe Simulationsgeschwindigkeit zu erzielen, ist bei allen Verfahren 1 gemäß den Fig. 2 bis 9 vorgesehen, dass die Sensormodelle 13, 13a, 13b auf wenigstens zwei Recheneinheiten 4, 4a, 4b, 4c mit ihren jeweils direkt zugreifbaren Speichern verteilt werden.

Zusätzlich ist vorgesehen, dass die Recheneinheiten 4b, 4c mit Sensormodellen 13a, 13b identifiziert werden, die statische Umgebungsdaten 14a als Eingangsgrößen haben. Zum Zweck der Simulation werden dann in den direkt zugreifbaren Speichern der identifizierten Recheneinheiten 4b, 4c die statischen Umgebungsdaten 14a abgelegt. Nach abgeschlossener Ablage der statischen Umgebungsdaten 14a wird die Simulation der Modelle 12, 13, 14 auf den Recheneinheiten 4 mit ihren jeweils direkt zugreifbaren Speichern synchron gestartet. Durch diese Verteilung der Modelle ist es möglich, dass die Sensormodelle 13, 13a, 13b, die statische Umgebungsdaten 14a als Eingangsgrößen benötigen, die statischen Umgebungsdaten 14a derjenigen identifizierten Recheneinheit 4b, 4c verwenden, auf der die jeweiligen Sensormodelle 13a, 13b selbst lokalisiert sind. Die Sensormodelle 13a, 13b können dadurch also von dem schnellen Zugriff auf den direkt zugreifbaren Speicher profitieren. Es ist demnach nicht erforderlich - und auch nicht vorgesehen - dass während der Simulation statische Umgebungsdaten 14a zwischen den Recheneinheiten 4, 4a, 4b, 4c des Simulators 5 übertragen werden müssen. Dadurch wird ein großer Geschwindigkeitseffekt erzielt, da die statischen Umgebungsdaten 14a gegenüber den dynamischen Umgebungsdaten 14b von erheblicher Größe sind. Dadurch wird die gewünschte Simulation in manchen Fällen überhaupt erst ermöglicht, beispielsweise wenn der Simulation Geschwindigkeitsanforderungen zu Grunde liegen, bei klassischen HIL-Simulationen ist dies die Anforderung nach einer Echtzeitsimulation.

Unter Berücksichtigung dieser allgemeinen Lehre zur Verteilung insbesondere der Sensormodelle 13a, 13b, die statische Umgebungsdaten 14a als Eingangsgrößen haben, sind verschiedene Spielarten der Modellverteilung denkbar, die unterschiedliche Vorteile aufweisen. Bei dem Ausführungsbeispiel gemäß Fig. 2 ist beispielsweise realisiert, dass die Sensormodelle 13a, 13b so auf die Recheneinheiten 4b, 4c des Simulators 5 verteilt werden, dass die betroffenen Recheneinheiten 4b, 4c ausschließlich die Sensormodelle 13a, 13b berechnen.

In Fig. 3 ist dargestellt, dass die Simulation auf dem Simulator 5 auch mehrere Fahrzeugmodelle 12a, 12b umfassen kann. In dem dargestellten Ausführungsbeispiel wird jedes weitere Fahrzeugmodell 12b auf einer weiteren Recheneinheit 4c berechnet (symbolisiert durch die hintereinander gefächerten Blöcke). Auf anderen Recheneinheiten 4b (ebenfalls als hintereinander gefächerte Blöcke dargestellt) werden solche Sensormodelle 13a berechnet, die statische Umgebungsdaten 14a als Eingangsgrößen benötigen. In dem dargestellten Ausführungsbeispiel erfolgt die Berechnung der Fahrzeugmodelle 12 und der Sensormodelle 13 unabhängig voneinander auf verschiedenen Recheneinheiten 4. Wenn es die Rechenleistung der Recheneinheit 4b zuließe, könnten auch mehrere Sensormodelle 13 auf einer einzigen Recheneinheit 4b berechnet werden, wodurch der Einsatz von Recheneinheiten 4 reduziert werden könnte. Gleiches gilt natürlich sinngemäß auch für die Berechnung von Fahrzeugmodellen 12; auch hier lassen sich mehrere Fahrzeugmodelle 12 auf einer einzigen Recheneinheit 4 berechnen, sofern es die Rechenleistung der betreffenden Recheneinheit 4 zulässt.

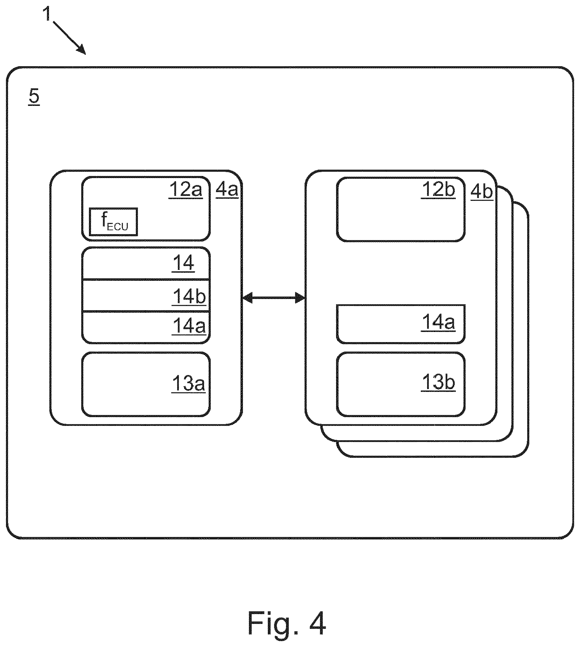

Aus Fig. 4 ist eine andere mögliche Variante der Verteilung von Modellen 12, 13, 14 auf verschiedene Recheneinheiten 4 dargestellt. Der Verteilung liegt die Überlegung zugrunde, dass ein Fahrzeugmodell 12a, 12b und die dem Fahrzeugmodell 12a, 12b zugehörigen Sensormodelle 13a, 13b auf einer Recheneinheit 4a, 4b und deren direkt zugreifbarem Speicher abgelegt werden. Im vorliegenden Fall ist sogar realisiert, dass jedes Fahrzeugmodell 12a, 12b mit seinen zugehörigen Sensormodellen 13a, 13b auf einer separaten Recheneinheit 4a, 4b abgelegt wird. Vorteilhaft ist die Erhaltung des logischen Zusammenhangs zwischen den verschiedenen Modellen beispielsweise hinsichtlich der leichten Austauschbarkeit eines Fahrzeugmodells 12, da hier jeweils nur eine einzige Recheneinheit 4 bei Austausch eines Fahrzeugmodells 12 bearbeitet werden muss. Dies erhöht die Modularität und die Wartbarkeit der Simulation und des Simulationsaufbaus.

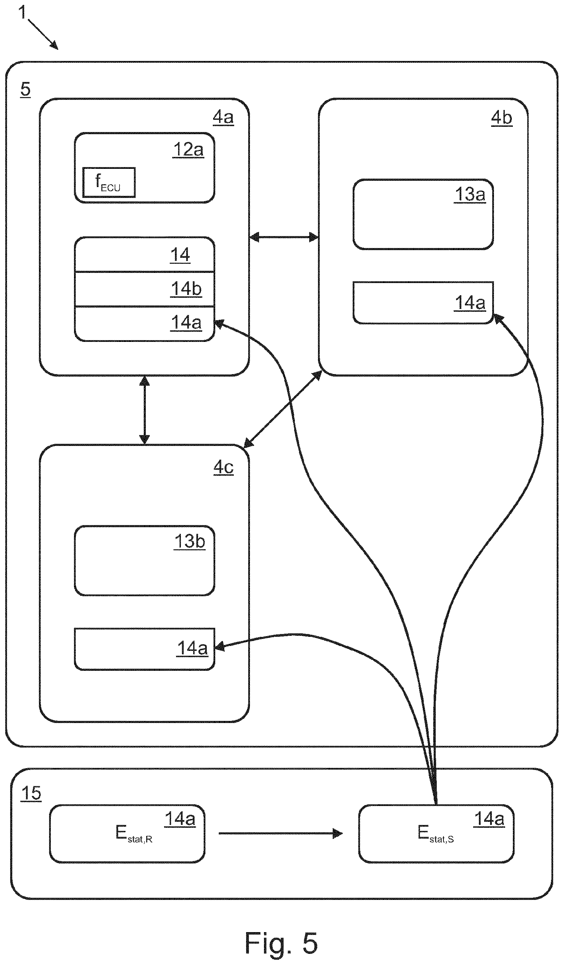

In den Fig. 5 bis 8 sind verschiedene Varianten und Ausgestaltungen der Idee dargestellt, dass vor dem Start der Simulation die statischen Umgebungsdaten 14a von einem Rohformat E_{stat,R} in ein Datenstrukturformat E_{stat,S} transformiert werden. Bei dem Rohformat E_{stat,R} der statischen Umgebungsdaten 14a handelt es sich um eine allgemeine Beschreibung der statischen Umgebungsdaten, die weder für eine spezielle Simulationsumgebung noch für eine bestimmte Hardware gedacht ist. Um diese Daten auf den Recheneinheiten 4 des Simulators 5 zugänglich und interpretierbar zu machen, müssen sie in das Datenstrukturformat E_{stat,S} transformiert werden. Dieser Übertragungsvorgang ist vergleichsweise zeitaufwendig und wird daher aus dem Simulationsablauf ausgelagert und der Durchführung der Simulation vorangestellt. Dadurch ist eine erhebliche Zeitersparnis möglich, insbesondere wenn Simulationen erneut auf der gleichen Modellgrundlage durchgeführt werden. Vor dem Start der Simulation auf den Recheneinheiten 4 wird im Rahmen der Synchronisation beispielsweise überprüft, ob auf allen identifizierten Recheneinheiten 4b, 4c ein Prozessor-spezifisches Flag gesetzt ist, das anzeigt, dass die statischen Umgebungsdaten in dem Datenstrukturformat E_{stat,S} vorliegen.

Bei dem Ausführungsbeispiel gemäß Fig. 5 ist vorgesehen, dass die statischen Umgebungsdaten 14a vor der Ablage in den direkt zugreifbaren Speichern der identifizierten Recheneinheiten 4b, 4c auf einem Host-Rechner 15 von einem Rohformat E_{stat,R} in ein Datenstrukturformat E_{stat,S} transformiert werden. Von dem Host-Rechner 15 werden die transformierten statischen Umgebungsdaten 14a dann auf die einzelnen Recheneinheiten 4a, 4b, 4c übertragen. Neben den identifizierten Recheneinheit 4b, 4c erhält auch die Recheneinheit 4a die statischen Umgebungsdaten 14a, da auf ihr das komplette Umgebungsmodell 14 berechnet wird. Für die Transformation muss der Host-Rechner 15 genaue Kenntnis von den soft- und hardwaremäßigen Gegebenheiten auf den Recheneinheiten 4 haben. Wenn der Simulator 5 beispielsweise über eine weitere Recheneinheit verfügte, auf der nur ein Fahrzeugmodell berechnet würde, dann würden die statischen Umgebungsdaten auf diese Recheneinheit nicht übertragen werden.

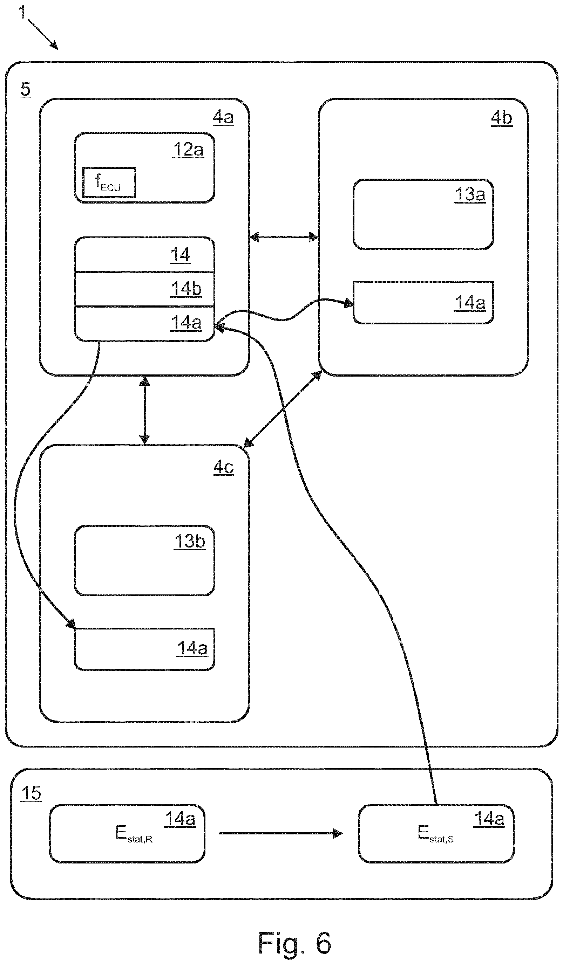

Das Ausführungsbeispiel gemäß Fig. 6 zeigt eine Variante zu dem Verteilungsschema der statistischen Umgebungsdaten 14a gemäß Fig. 5. Hier werden die auf dem Host-Rechner 15 in ein Datenstrukturformat E_{stat,S} transformierten statischen Umgebungsdaten 14a in den Speicher einer Recheneinheit 4a übertragen und von dort aus in den direkt zugreifbaren Speicher der weiteren identifizierten Recheneinheiten 4b, 4c übertragen und dort abgelegt. Ansonsten entsprechen die Gegebenheiten denen in Fig. 5.

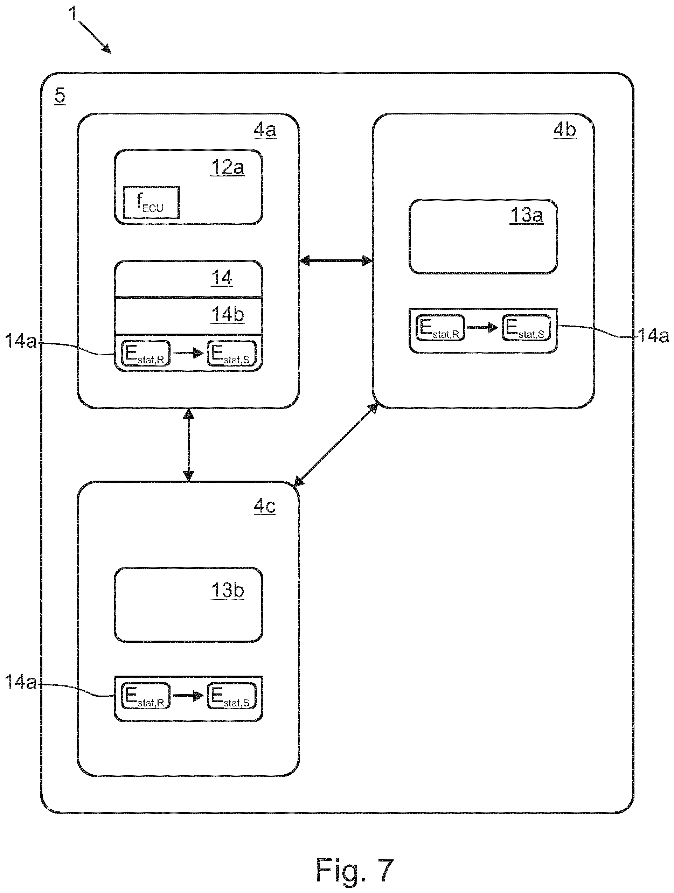

Eine andere Strategie verfolgt das Verfahren gemäß Fig. 7. Hier werden die statischen Umgebungsdaten 14a zunächst im Rohformat E_{stat,R} in dem direkt zugreifbaren Speicher einer identifizierten Recheneinheit 4 oder in den direkt zugreifbaren Speichern mehrerer identifizierter Recheneinheiten 4a, 4b, 4c abgelegt. Dort werden die im Rohformat E_{stat,R} vorliegenden statischen Umgebungsdaten 14a dann von der jeweiligen Recheneinheit 4a, 4b, 4c in ein Datenstrukturformat E_{stat,S} transformiert. Diese Vorgehensweise eignet sich insbesondere bei einer heterogenen Hardware mit unterschiedlichen Recheneinheiten 4, 4a, 4b, 4c. Von der Hardware der jeweiligen Recheneinheit 4 abhängige Besonderheiten werden hier quasi automatisch berücksichtigt.

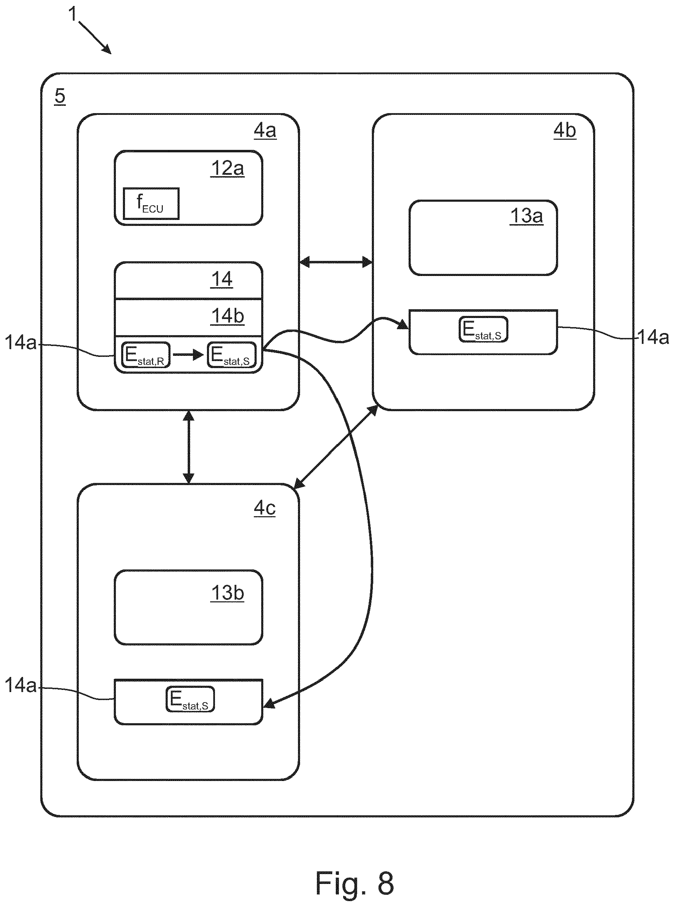

Die Ausgestaltung gemäß Fig. 8 eignet sich insbesondere dann, wenn die Recheneinheiten 4, 4a, 4b, 4c vergleichbar sind, so dass die Transformation der statischen Umgebungsdaten 14a stellvertretend nur auf einer Recheneinheit 4a vollzogen werden kann, wobei das Transformationsergebnis in Form der statischen Umgebungsdaten 14a im Datenstrukturformat E_{stat,S} dann für die anderen Recheneinheiten 4b, 4c ebenfalls verwendet werden kann. Es ist also vorgesehen, dass die statischen Umgebungsdaten 14a in dem direkt zugreifbaren Speicher einer Recheneinheit 4a von der Recheneinheit 4a von einem Rohformat E_{stat,R} in ein Datenstrukturformat E_{stat,S} transformiert werden und von dieser Recheneinheit 4a auf die identifizierten Recheneinheiten 4b, 4c übertragen und dort abgelegt werden.

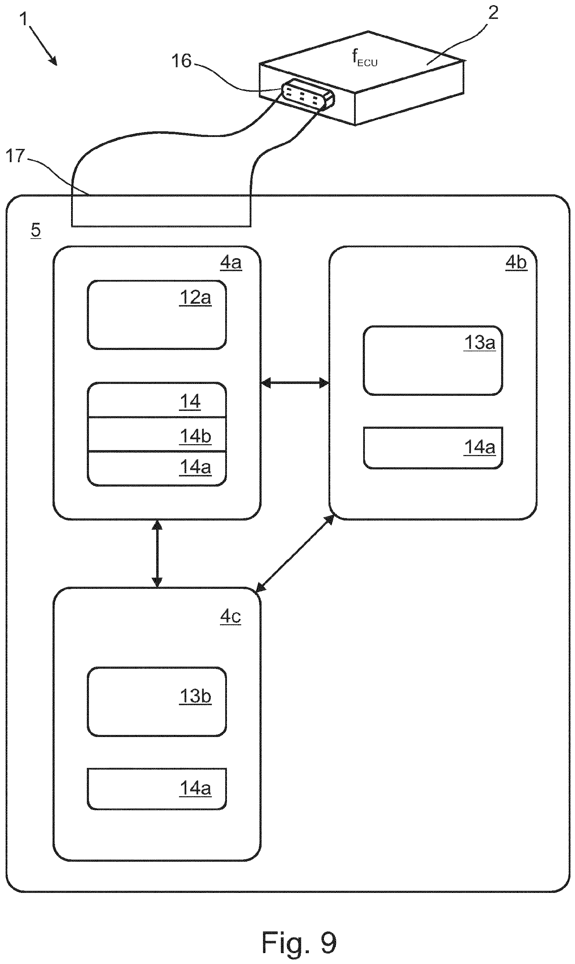

In den Fig. 2 bis 8 ist das Steuergerät immer als Bestandteil des Fahrzeugmodells 12a in Erscheinung getreten. Bei dem Ausführungsbeispiel gemäß Fig. 9 liegt das Steuergerät 2 jedoch real vor, also nicht in Form eines virtuellen Steuergerätes. Die Steuergerätefunktion f_{ECU} ist also in dem Steuergerät 2 implementiert. Um die Steuergerätefunktion f_{ECU} testen zu können, müssen die entsprechenden Eingangsgrößen über entsprechende Schnittstellen bereitgestellt werden. Die Vorgehensweise ist hier folglich, dass die zu testende Steuergerätefunktion f_{ECU} auf dem realen Steuergerät 2 implementiert ist und das reale Steuergerät 2 über seine Steuergerät-I/O-Schnittstelle 16 mit einer entsprechenden Simulator-I/O-Schnittstelle 17 mit dem Simulator 5 verbunden ist und die simulierten Sensordaten der Sensormodelle 13 auf das reale Steuergerät 2 übertragen werden. Umgekehrt kann der Simulator 5 auch auf dem Steuergerät 2 berechnete und von dem Steuergerät 2 ausgegebene Signale empfangen und der weiteren Simulation zuführen.

### Bezugszeichen

- 1: Verfahren
- 2: Steuergerät
- 3: Fahrzeuge
- 3a: Fahrzeug
- 3b: Fahrzeug
- 4: Recheneinheiten
- 4a: Recheneinheit
- 4b: Recheneinheit
- 4c: Recheneinheit
- 5: Simulator
- 6: Umgebungssensoren
- 6a: Umgebungssensor
- 6b: Umgebungssensor
- 6c: Umgebungssensor
- 6d: Umgebungssensor
- 7: Umgebung
- 8: Straße
- 9: Gebäude
- 10: Verkehrsschilder
- 11: Lichtzeichen
- 12: Fahrzeugmodelle
- 12a: Fahrzeugmodell
- 12b: Fahrzeugmodell
- 13: Sensormodelle
- 13a: Sensormodell
- 13b: Sensormodell
- 14: Umgebungsmodell
- 14a: statistische Umgebungsdaten
- 14b: dynamische Umgebungsdaten
- 15: Host-Rechner
- 16: Steuergerät-I/O-Schnittstelle
- 17: Simulator-I/O-Schnittstelle
- E_{stat,R}: Rohformat
- E_{stat,S}: Datenstrukturformat
- f_{ECU}: Steuergerätefunktion

## Patentansprüche

1. Verfahren (1) zum Test wenigstens einer Steuergerätefunktion (f_{ECU}) wenigstens eines Steuergeräts (2) wenigstens eines ersten Fahrzeugs (3a), mittels eines mehrere Recheneinheiten (4a, 4b, 4c) aufweisenden Simulators (5), wobei das erste Fahrzeug wenigstens einen Umgebungssensor (6a) aufweist,
wobei eine Mehrzahl von Umgebungssensoren (6a, 6b, 6c, 6d) des ersten Fahrzeugs (3a) und/oder wenigstens eines weiteren Fahrzeugs (3b) das wenigstens eine Steuergerät (2) und/oder weitere Steuergeräte mit Sensordaten der Umgebungssensoren (6a, 6b, 6c, 6d) speisen, die wenigstens eine Steuergerätefunktion (f_{ECU}) zumindest einen Teil der Sensordaten als Eingangsgrößen verarbeitet, und das erste Fahrzeug (3a) und, soweit vorhanden, die weiteren Fahrzeuge (3b) sich in einer eine Verkehrssituation darstellenden Umgebung (7) befinden,
wobei das erste Fahrzeug (3a) mittels eines ersten Fahrzeugmodells (12a), und, soweit vorhanden, die weiteren Fahrzeuge (3b) mittels weiterer Fahrzeugmodelle (12b) die Umgebungssensoren (6, 6a, 6b) mittels Sensormodellen (13, 13a, 13b) und die Umgebung (7) mittels eines Umgebungsmodells (14) mit den Recheneinheiten (4) des Simulators (5) simuliert werden, wobei die Modelle alleine oder in Gruppen auf wenigstens zwei Recheneinheiten (4a, 4b) mit jeweils direkt zugreifbarem Speicher verteilt werden,
wobei das Umgebungsmodell (14) statische (14a) und dynamische (14b) Umgebungsdaten umfasst,
wobei die Sensormodelle (13) als Eingangsgrößen die statischen (14a) und/oder dynamischen (14b) Umgebungsdaten aufweisen,
**dadurch gekennzeichnet,**
**dass** die Sensormodelle (13, 13a, 13b) auf wenigstens zwei Recheneinheiten (4, 4a, 4b, 4c) mit ihren jeweils direkt zugreifbaren Speichern verteilt werden,
**dass** die Recheneinheiten (4b, 4c) mit Sensormodellen (13a, 13b) identifiziert werden, die statische Umgebungsdaten (14a) als Eingangsgrößen haben,
**dass** in den direkt zugreifbaren Speichern der identifizierten Recheneinheiten (4b, 4c) die statischen Umgebungsdaten (14a) abgelegt werden,
**dass** nach abgeschlossener Ablage der statischen Umgebungsdaten (14a) die Simulation der Modelle (12, 13, 14) auf den Recheneinheiten (4, 4a, 4b, 4c) mit ihren jeweils direkt zugreifbaren Speichern synchron gestartet wird,
**dass** die Sensormodelle (13a, 13b), die statische Umgebungsdaten (14a) als Eingangsgrößen aufweisen, die statischen Umgebungsdaten (14a) derjenigen identifizierten Recheneinheit (4b, 4c) mit ihrem direkt zugreifbaren Speicher verwenden, auf der die jeweiligen Sensormodelle (13a, 13b) selbst lokalisiert sind.

2. Verfahren (1) nach Anspruch 1, **dadurch gekennzeichnet, dass** die statischen Umgebungsdaten (4a) vor dem Start der Simulation von einem Rohformat (E_{stat,R}) in ein Datenstrukturformat (E_{stat,S}) transformiert werden.

3. Verfahren (1) nach Anspruch 2, **dadurch gekennzeichnet, dass** die statischen Umgebungsdaten (14a) vor der Ablage in den direkt zugreifbaren Speichern der identifizierten Recheneinheiten (4b, 4c) auf einem Host-Rechner (15) von einem Rohformat (E_{stat,R}) in ein Datenstrukturformat (E_{stat,S}) transformiert werden.

4. Verfahren (1) nach Anspruch 3, **dadurch gekennzeichnet, dass** die auf dem Host-Rechner (15) in ein Datenstrukturformat (E_{stat,S}) transformierten statischen Umgebungsdaten (14a) in den Speicher einer Recheneinheit (4a), insbesondere in den direkt zugreifbaren Speicher einer identifizierten Recheneinheit (4), übertragen werden und von dort aus in den direkt zugreifbaren Speicher der weiteren identifizierten Recheneinheiten (4b, 4c) übertragen und dort abgelegt werden.

5. Verfahren (1) nach Anspruch 2, **dadurch gekennzeichnet, dass** die statischen Umgebungsdaten (14a) nach der Ablage in dem direkt zugreifbaren Speicher einer identifizierten Recheneinheit (4) oder in den direkt zugreifbaren Speichern mehrerer identifizierter Recheneinheiten (4a, 4b, 4c) von der jeweiligen Recheneinheit (4a, 4b, 4c) von einem Rohformat (E_{stat,R}) in ein Datenstrukturformat (E_{stat,S}) transformiert werden.

6. Verfahren (1) nach Anspruch 5, **dadurch gekennzeichnet, dass** die statischen Umgebungsdaten (14a) in dem direkt zugreifbaren Speicher einer Recheneinheit (4), insbesondere in dem direkt zugreifbaren Speicher einer identifizierten Recheneinheit (4b, 4c), von der Recheneinheit (4a) von einem Rohformat (E_{stat,R}) in ein Datenstrukturformat (E_{stat,S}) transformiert werden und von dieser Recheneinheit 4a auf die identifizierten Recheneinheiten (4b, 4c) übertragen und dort abgelegt werden.

7. Verfahren (1) nach einem der Ansprüche 1 bis 6, **dadurch gekennzeichnet, dass** die Sensormodelle (13a, 13b) auf möglichst wenige Recheneinheiten (4b, 4c) des Simulators (5) verteilt werden.

8. Verfahren (1) nach einem der Ansprüche 1 bis 6, **dadurch gekennzeichnet, dass** ein Fahrzeugmodell (12a, 12b) und die zu dem Fahrzeugmodell (12a, 12b) zugehörigen Sensormodelle (13a, 13b) auf einer Recheneinheit (4a, 4b) und deren direkt zugreifbarem Speicher abgelegt werden, insbesondere jedes Fahrzeugmodell (12a, 12b) mit seinen zugehörigen Sensormodellen (13a, 13b) auf einer separaten Recheneinheit (4a, 4b) abgelegt wird.

9. Verfahren (1) nach einem der Ansprüche 1 bis 8, **dadurch gekennzeichnet, dass** die zu testende Steuergerätefunktion (f_{ECU}) auf einem realen Steuergerät (2) implementiert ist und das reale Steuergerät (2) über seine Steuergerät-I/O-Schnittstelle (16) mit einer entsprechenden Simulator-I/O-Schnittstelle (17) mit dem Simulator (5) verbunden ist und die simulierten Sensordaten der Sensormodelle (13), auf das reale Steuergerät (2) übertragen werden.

10. Verfahren (1) nach einem der Ansprüche 1 bis 8, **dadurch gekennzeichnet, dass** die zu testende Steuergerätefunktion (f_{ECU}) auf einem virtuellen Steuergerät implementiert ist und das virtuelle Steuergerät über seine virtuelle Steuergerät-I/O-Schnittstelle im Rahmen der Simulation die simulierten Sensordaten der Sensormodelle (13) erhält.

11. Verfahren (1) nach einem der Ansprüche 1 bis 10, **dadurch gekennzeichnet, dass** das erste Fahrzeugmodell (12a), und, soweit vorhanden, die weiteren Fahrzeugmodelle (12b), die Sensormodelle (13) und das Umgebungsmodell (14) gemäß einer ersten Konfiguration auf die Recheneinheiten (4) und deren direkt zugreifbare Speicher verteilt werden, dass während einer ersten Simulation der Modelle (12, 13, 14) auf den Recheneinheiten (4) die Auslastung der Recheneinheiten (4) ermittelt wird und dass auf Grundlage der ermittelten Auslastungen der Recheneinheiten (4) eine Umverteilung der Modelle zu einer weiteren Konfiguration vorgenommen wird, so dass eine gleichmäßigere Auslastung der Recheneinheiten (4) bei der Simulation der Modelle (12, 13, 14) resultiert.

12. Simulator, der eingerichtet ist, das Verfahren (1) nach einem der Ansprüche 1 bis 11 auszuführen.
